# EUROPEAN PATENT SPECIFICATION

(11) **EP 1 609 847 B1**
(45) Date of publication and mention of the grant of the patent: **21.03.2007**
(21) Application number: 05013619.1
(22) Date of filing: 23.06.2005
(51) Int. Cl.: C11D 11/00, C11D 7/34, C11D 7/06, C11D 7/32, H01L 21/306

(54) **Cleaning composition for semiconductor components and process for manufacturing semiconductor device**
Reinigungszusammensetzung für Halbleiterkomponente und Verfahren zur Herstellung eines Halbleitergeräts
Composition de nettoyage de composants de semi-conducteur et procédé de fabrication d'un dispositif semi-conducteur

(30) Priority: 25.06.2004 JP 2004187517
(43) Date of publication of application: 28.12.2005
(73) Proprietor: JSR Corporation, Tokyo (JP)
(72) Inventor: Hattori, Masayuki, Tokyo (JP); Namie, Yuji, Tokyo (JP); Kawahashi, Nobuo, Tokyo (JP)
(74) Representative: TBK-Patent

(56) References cited:
- EP-A- 1 020 501
- EP-A- 1 077 241
- EP-A- 1 310 989
- US-A- 6 117 220
- US-A1- 2003 124 959
- US-A1- 2003 228 763
- US-A1- 2005 090 109
- US-B1- 6 440 856

## Description

### TECHNICAL FIELD

The present invention relates to a cleaning composition for semiconductor components and a process for manufacturing a semiconductor device. More particularly, the invention relates to a cleaning composition for semiconductor components comprising a specific water-soluble polymer and a specific compound and a process for manufacturing a semiconductor device comprising a step of cleaning a semiconductor component with the cleaning composition.

### BACKGROUND OF THE INVENTION

In a process for manufacturing a semiconductor device, chemical mechanical polishing (CMP) has been paid attention. The chemical mechanical polishing has an advantage that a planarization step can be shortened as compared with conventional techniques, e.g., etch back technique such as RIE (reactive ion etching) and reflow technique. Further, the chemical mechanical polishing has an advantage that it hardly suffers pattern dependence and hence excellent planarization can be realized. Such chemical mechanical polishing has been applied to, for example, planarization of metal wiring portion or planarization of interlayer insulating films in multilayer semiconductor substrates.

However, it is known that when a semiconductor component for use in a semiconductor device is planarized by chemical mechanical polishing, impurities such as abrasives, sodium ions and potassium ions, which have been contained in a polishing aqueous dispersion used for the chemical mechanical polishing, remain on the polished surface of the semiconductor component after the chemical mechanical polishing. These impurities have evil influence on the properties and performance of the semiconductor device, so that they need to be removed by cleaning.

Under such circumstances, the following cleaning liquids have been proposed in order to clean substrates having metal wiring portion. For example, there are disclosed a cleaning liquid containing oxalic acid, ammonium oxalate or polyaminocarboxylic acid (see Japanese Patent Laid-Open Publication No. 11-131093/1999), a cleaning treatment agent containing an organic acid such as citric acid and a complexing agent such as hexametaphosphoric acid (see Japanese Patent No. 3219020), a cleaning agent containing a surfactant having an alkyl group and an ethylene oxide structure (see Japanese Patent Laid-Open Publication No. 11-121418/1999), a cleaning agent using a combination of two complexing agents, such as a combination of ethylenediaminetetrakismethylphosphonic acid and acetic acid (see Japanese Patent Laid-Open Publication No. 09-157692/1997), and a cleaning liquid for semiconductor components containing a water-soluble (co)polymer having, as essential constituents, a sulfonic acid group and/or a carboxyl group (see Japanese Patent Laid-Open Publication No. 2001-64689). Further relevant art. is disclosed in EP 1310989-A and US 2003/0228763-A.

In the case of using the above cleaning liquids, however, there is a problem that it is difficult to sufficiently remove impurities remaining on the substrate after chemical mechanical polishing, such as abrasives, polishing dusts, sodium ions and potassium ions. Moreover, there is another problem that a cleaning liquid of high concentration needs to be used in order to exert the cleaning effect, and waste water treatment or the like becomes a heavy burden to the environment.

### OBJECT OF THE INVENTION

The present invention has been made to solve such problems associated with the prior art as described above, and it is an object of present invention to provide a cleaning composition for semiconductor components which exerts a high cleaning effect on impurities remaining on a polished surface of a semiconductor component after chemical mechanical polishing and becomes little burden to the environment.

It is another object of the present invention to provide a process for manufacturing a semiconductor device comprising a step of cleaning a semiconductor component with the cleaning composition.

### DISCLOSURE OF THE INVENTION

The present inventors have diligently studied to solve the above problems, and as a result, they have found that a cleaning composition for semiconductor components containing a water-soluble polymer having a specific molecular weight and an ammonium hydroxide exerts a high cleaning effect on impurities and becomes little burden to the environment. Based on the finding, the present invention has been accomplished.

That is to say, the cleaning composition for semiconductor components according to the present invention comprises a water-soluble polymer (a) having a weight-average molecular weight in terms of sodium polystyrenesulfonate, as measured by gel permeation chromatography, of 1,000 to 100,000 and a compound (b) represented by the following formula (1):

NR₄OH (1)

wherein each R is independently a hydrogen atom or an alkyl group of 1 to 6 carbon atoms.

The cleaning composition preferably comprises at lease one of the water-soluble polymer and the compound (b) in at least one state of the dissociative state and the recombined state with a counter ion after dissociation.

The water-soluble polymer (a) preferably has a carboxyl group.

The compound (b) is preferably tetramethylammonium hydroxide.

The cleaning composition preferably further comprises at least one agent selected from the group consisting of an antioxidant (c) and a complexing agent (d), and the semiconductor component is preferably a copper semiconductor substrate.

The process for manufacturing a semiconductor device according to the present invention comprises chemical mechanical polishing a semiconductor component, and cleaning the semiconductor component with the above-mentioned cleaning composition, and the semiconductor component is preferably a copper semiconductor substrate.

### DESCRIPTION OF THE PREFERRED EMBODIMENTS

The present invention is described in detail hereinafter.

The cleaning composition for semiconductor components according to the invention comprises a water-soluble polymer (a) having a weight-average molecular weight in terms of sodium polystyrenesulfonate, as measured by gel permeation chromatography, of 1,000 to 100,000 and a compound (b) represented by the following formula (1):

NR₄OH (1)

wherein each R is independently a hydrogen atom or an alkyl group of 1 to 6 carbon atoms.

In the present invention, the above components are preferably blended with an appropriate solvent. The composition may further comprise at least one agent selected from the group consisting of an antioxidant (c) and a complexing agent (d).

### <Water-Soluble Polymer (a)>

The water-soluble polymer (a) has a weight-average molecular weight in terms of sodium polystyrenesulfonate, as measured by gel permeation chromatography (solvent: a mixed solvent of water, acetonitrile and sodium sulfate, 2,100/900/15, by weight), of 1,000 to 100,000, preferably 2,000 to 30,000, particularly preferably 3,000 to 20,000. By the use of the water-soluble polymer (a) having a weight-average molecular weight in this range, a cleaning composition for semiconductor components having high cleaning power and showing ease of handling can be obtained.

The water-soluble polymer (a) is not specifically restricted provided that its weight-average molecular weight is in the above range, but the water-soluble polymer (A) preferably has a carboxyl group. The water-soluble polymer (a) having a carboxyl group is, for example, a homopolymer of a monomer having a carboxyl group, a copolymer formed from two or more monomers having a carboxyl group, or a copolymer formed from one or two or more monomers having a carboxyl group and one or two or more of other monomers.

The monomer having a carboxyl group is, for example, a monomer having a carboxyl group and a polymerizable double bond simultaneously in the molecule. Examples of such monomers include acrylic acid, methacrylic acid, α-haloacrylic acid, maleic acid, maleic anhydride, itaconic acid, vinylacetic acid, allylacetic acid, fumaric acid, phosphinocarboxylic acid and β-carboxylic acid. Of these monomers, acrylic acid, methacrylic acid and itaconic acid are preferable because excellent cleaning power can be obtained.

In the case where the water-soluble polymer (a) is a copolymer of a monomer having a carboxyl group and another monomer, examples of other monomers include unsaturated alcohol compounds, aromatic vinyl compounds, hydroxyl group-containing (meth)acrylic ester compounds, (meth)acrylic acid alkyl ester compounds, aliphatic conjugated diene compounds, vinyl cyanogen compounds, amide compounds having polymerizable double bond and phosphonic acids having polymerizable double bond.

Examples of the unsaturated alcohol compounds include vinyl alcohol, ally alcohol, methylvinyl alcohol, ethylvinyl alcohol and vinylglycolic acid. Examples of the aromatic vinyl compounds include styrene, α-methylstyrene, vinyltoluene and p-methylstyrene. Examples of the hydroxyl group-containing (meth)acrylic ester compounds include hydroxymethyl (meth)acrylate, hydroxyethyl (meth)acrylate, hydroxypropyl (meth)acrylate, polyethylene glycol mono(meth)acrylate, polypropylene glycol mono(meth)acrylate, glycerol mono(meth)acrylate, glycerol di (meth) acrylate, polytetramethylene glycol mono (meth) acrylate, polytetramethylene glycol di (meth) acrylate, butanediol (meth)acrylate and hexanediol (meth)acrylate. Examples of the (meth)acrylic acid alkyl ester compounds include methyl (meth)acrylate, ethyl (meth)acrylate and octyl (meth)acrylate. Examples of the aliphatic conjugated diene compounds include butadiene, isoprene, 2-chloro-1,3-butadiene and 1-chloro-1,3-butadiene. Examples of the vinyl cyanogen compounds include (meth)acrylonitrile. Examples of the amide compounds having polymerizable double bond include (meth)acrylamide and alkyl(meth)acrylamide. Examples of the phosphonic acids having polymerizable double bond include vinylphosphonic acid. The alkyl group in these examples is, for example, a straight-chain or branched alkyl group of 1 to 8 carbon atoms.

In the case where the water-soluble polymer (a) is a copolymer of a monomer having a carboxyl group and another monomer, the content of structural units derived from the other monomer is preferably not more than 30% by mol based on the total amount of structural units.

In the case where the water-soluble polymer (a) is the (co)polymer of a monomer having a carboxyl group or the copolymer of a monomer having a carboxyl group and another monomer, the (co)polymer can be obtained by the following polymerization process.

Using the monomer component mentioned above, polymerization reaction is carried out in the presence of an appropriate polymerization initiator at a temperature of 20 to 120°C, preferably 40 to 100°C, for a period of 0.1 to 20 hours, preferably 1 to 15 hours, whereby the (co)polymer can be prepared. In this process, the (co)polymer can be prepared by successive polymerization wherein the monomer component used for the polymerization is added successively. More specifically, this successive polymerization means a polymerization process wherein the monomer component is introduced into the polymerization system within a given period of time in fixed amounts per unit time or with changing the amounts. It is preferable to use this process because polymerization reaction can be carried out with excellent reproducibility.

The polymerization reaction can be carried out in the presence of a solvent. The solvent is, for example, water or a mixture of water and an organic solvent that is miscible with water. Examples of the organic solvents include tetrahydrofuran, 1,4-dioxane and alcohols of 1 to 4 carbon atoms. Of these solvents, water is preferable as the polymerization solvent.

It is preferable that soaps should not be allowed to coexist in the polymerization reaction.

The cleaning composition for semiconductor components of the invention desirably comprises the water-soluble polymer (a) in an amount of preferably 0.01 to 1% by mass, more preferably 0.02 to 0.5% by mass, based on the total amount of the composition. The water-soluble polymer (a) may be contained in the composition in any state of the unchanged state, the dissociative state and the recombined state with a counter ion after dissociation.

When the water-soluble polymer (a) has carboxyl groups, a part of the carboxyl groups may form a salt. The counter cation to form the salt is, for example, an ammonium ion. The content of the carboxyl groups to form the salt is preferably not more than 50% by mol based on the total amount of the carboxyl groups.

### <Compound (b)>

The compound (b) is an ammonium hydroxide represented by the aforesaid formula (1).

Examples of the compounds (b) include tetramethylammonium hydroxide, tetraethylammonium hydroxide, tetrapropylammonium hydroxide, tetraisopropylammonium hydroxide, tetrabutylammonium hydroxide and tetraisobutylammonium hydroxide. Of these compounds, tetramethylammonium hydroxide and tetraethylammonium hydroxide are preferable, and tetramethylammonium hydroxide is particularly preferable, because excellent cleaning power can be obtained.

The above compounds (b) can be used singly or as a mixture of two or more kinds.

The composition desirably comprises the compound (b) in an amount of preferably 0.01 to 1% by mass, more preferably 0.02 to 0.5% by mass, based on the total amount of the composition. The compound (b) may be contained in the composition in any state of the unchanged state, the dissociative state and the recombined state with a counter ion after dissociation.

### <Antioxidant (c) >

In order to prevent oxidation of metal wiring portion, the composition preferably further contains an antioxidant (c).

Examples of the antioxidants (c) include lactones and other antioxidants. Examples of the lactones include L-ascorbic acid, erysorbic acid and ascorbyl stearate. Examples of other antioxidants include gallic acid, chlorogenic acid, oxalic acid, catechin and dibutylhydroxytoluene.

Of the above compounds, L-ascorbic acid, erysorbic acid, gallic acid and oxalic acid are preferable from the viewpoint of excellent anti-oxidation properties.

The above antioxidants (c) may be used singly or in combination of two or more kinds.

The composition desirably comprises the antioxidant (c) in an amount of preferably not more than 5 parts by mass, more preferably 0.1 to 3.5 parts by mass, relative to 1 part by mass of the water-soluble polymer (a).

### <Complexing Agent (d)>

In order to prevent re-adhesion of metal impurities, the composition preferably further contains a complexing agent (d).

Examples of the complexing agents (d) include aminopolycarboxylic acids, polybasic acids (except oxalic acid), amino acids and other amino group-containing compounds. Examples of the aminopolycarboxylic acids include ethylenediaminetetraacetic acid (EDTA) trans-1,2-cyclohexanediaminetetraacetic acid (CyDTA), diethylenetriamine-pentaacetic acid (DTPA), N-(2-hydroxyethyl)ethylenediamine-N,N',N'-triacetic acid (EDTA-OH), nitrilotriacetic acid and hydroxyethyliminodiacetic acid. Examples of the polybasic acids (except oxalic acid) include maleic acid, malonic acid, tartaric acid, malic acid, succinic acid and citric acid. Examples of the amino acids include glycine, alanine, asparatic acid and methionine. Examples of the other amino group-containing compounds include ethylenediamine and ammonia.

Of the above compounds, ethylenediaminetetraacetic acid, citric acid, glycine, alanine, ethylenediamine and ammonia are preferable because they have excellent ability of inhibiting re-adhesion of metal impurities.

The above complexing agents (d) may be used singly or in combination of two or more kinds.

The composition desirably comprises the complexing agent (d) in an amount of preferably not more than 5 parts by mass, more preferably 0.1 to 3.5 parts by mass, relative to 1 part by mass of the water-soluble polymer (a).

### <Other Components>

In order to enhance cleaning power, the composition can further contain other components when needed, within limits not detrimental to the objects of the present invention.

Examples of the other components include other cleaning agent components and surfactants.

Examples of the other cleaning agent components include inorganic acids, such as hydrochloric acid and hydrofluoric acid, and peroxides, such as hydrogen peroxide.

These other cleaning agent components may be used singly or in combination of two or more kinds.

The composition desirably comprises the other cleaning agent components in amounts of preferably not more than 5 parts by mass, more preferably 0.1 to 3.5 parts by mass, relative to 1 part by mass of the water-soluble polymer (a).

Examples of the surfactants include anionic surfactants, nonionic surfactants or cationic surfactants.

Examples of the anionic surfactants include carboxylates, such as fatty acid soap and alkyl ether carboxylate; sulfonates, such as alkylbenzenesulfonate, alkylnaphthalenesulfonate and α-olefin sulfonate; sulfuric ester salts, such as higher alcohol sulfuric ester salt and alkyl ether sulfate; and phosphoric ester salts, such as alkylphosphoric ester.

Examples of the nonionic surfactants include ether type surfactants, such as polyoxyethylene alkyl ether; ether ester type surfactants, such as polyoxyethylene ether of glycerol ester; and ester type surfactants, such as polyethylene glycol fatty ester, glycerol ester and sorbitan ester.

Examples of the cationic surfactants include aliphatic amine salt and aliphatic ammonium salt.

The above surfactants may be used singly or in combination of two or more kinds.

The composition desirably comprises the surfactant in an amount of preferably not more than 1% by mass, more preferably not more than 0.5% by mass, based on the total amount of the composition.

### <Solvent>

The solvent used for the cleaning composition of the invention is, for example, water or a mixture of water and an organic solvent that is miscible with water. Of these solvents, water is preferable because water becomes little burden to the environment.

Examples of the organic solvents miscible with water include solvents exemplified as the organic solvents for use in the preparation of the water-soluble polymer (a).

### <Cleaning Composition for Semiconductor Components>

In the cleaning composition for semiconductor components of the invention, the total amount of sodium and potassium contained in the composition is preferably not more than 0.02 ppm, more preferably not more than 0.01 ppm, particularly preferably not more than 0.005 ppm. The amounts of sodium and potassium can be controlled by properly selecting the polymerization initiator, the polymerization solvent and the monomer, which are used for the polymerization reaction to prepare the water-soluble polymer (a), the compound (b), the antioxidant (c), the complexing agent (d), other components, the solvent, etc., or by properly purifying these components.

As the polymerization initiator, for example, hydrogen peroxide or ammonium persulfate is preferably employed, and it is preferable to avoid use of an initiator containing sodium or potassium as a counter cation, such as sodium persulfate.

The purification can be carried out by adopting a proper means, such as distillation of the compound or contact of the compound with an ion-exchange resin, according to the properties of the compound.

Each component of the cleaning composition of the invention may be added so that the content of the component is in the above range in the preparation of the composition. It is also possible that the components are blended to prepare a concentrated composition and the composition is diluted when it is used in the cleaning step. In the preparation of the concentrated composition, the concentration of each component is in the range of preferably 2 to 500 times, more preferably 10 to 100 times, the content of the component described above.

The composition of the invention is preferably used for cleaning semiconductor components, and the composition of the invention is more preferably used for cleaning copper semiconductor substrates among the semiconductor components.

### <Process for Manufacturing Semiconductor Device>

The process for manufacturing a semiconductor device according to the invention comprises a step of chemical mechanical polishing a semiconductor component, and cleaning the semiconductor component with the above-mentioned cleaning composition.

Examples of the semiconductor components include a semiconductor substrate, a magnetic head and a magnetic disc. The semiconductor substrate is specifically a semiconductor substrate comprising an insulating film and a pattern of a metal that is a wiring material, a multilayer semiconductor substrate having an interlayer insulating film, or the like.

The semiconductor substrate comprising an insulating film and a pattern of a metal that is a wiring material is more specifically, for example, a semiconductor substrate having a wafer that is made of silicon or the like, an insulating film that is formed on the wafer and has a depressed portion for wiring, such as a trench, a barrier metal film that is formed so as to cover the insulating film and the trench, and a wiring material film that is formed on the barrier metal film and filled in the trench. Such a semiconductor substrate is chemically mechanically polished in accordance with a conventional method to remove excess wiring material and barrier metal material and then subjected to a cleaning step.

The multilayer semiconductor substrate having an interlayer insulating film is more specifically, for example, a semiconductor substrate obtained by laminating an insulating film on a semiconductor substrate having been chemically mechanically polished in accordance with a conventional method and then subjected to a cleaning step. Such a multilayer semiconductor substrate is further chemically mechanically polished in accordance with a conventional method to planarize the insulating film and then subjected to a cleaning step.

The semiconductor component is preferably a semiconductor substrate whose wiring material is copper.

The insulating film is, for example, a film formed by a vacuum process such as chemical vapor deposition, and examples of such films include a silicon oxide film (e.g., PETEOS film (plasma enhanced-TEOS film), HDP film (high density plasma enhanced-TEOS film) and silicon oxide film obtained by thermal CVD process), a boron phosphorus silicate film (BPSG film) obtained by adding small amounts of boron and phosphorus to SiO₂, an insulating film called FSG (fluorine-doped silicate glass) obtained by doping SiO₂ with fluorine, an insulating film called SiON (silicon oxynitride), silicon nitride, and a low-dielectric constant insulating film.

The low-dielectric constant insulating film is, for example, an interlayer insulating film comprising a polymer obtained by plasma polymerization of a silicon-containing compound, such as alkoxysilane, silane, alkylsilane, arylsilane, siloxane or alkylsiloxane, in the presence of oxygen, carbon monoxide, carbon dioxide, nitrogen, argon, H₂O, ozone, ammonia or the like, an interlayer insulating film comprising polysiloxane, polysilazane, polyarylene ether, polybenzoxazole, polyimide, silsesquioxane or the like, or a silicon oxide-based low-dielectric constant insulating film.

The silicon oxide-based low-dielectric constant insulating film can be obtained by, for example, coating a wafer with a raw material by a spin-coating method and then heating the wafer in an oxidizing atmosphere. Examples of the silicon oxide-based low-dielectric constant insulating films obtained as above include a HSQ film (hydrogen silsesquioxane film) using triethoxysilane as a raw material, a MSQ film (methyl silsesquioxane film) using tetraethoxysilane and a small amount of methyltrimethoxysilane as raw materials, and a low-dielectric constant insulating film using another silane compound as a raw material.

Further, an insulating film having much lower dielectric constant, which is obtained by mixing proper organic polymer particles with the raw material in the production of a low-dielectric constant insulating film, is also employable. The organic polymer is burnt away to form pores in the heating step, and hence, the insulating film exerts much lower dielectric constant. Examples of the proper organic polymer particles include "NEWPOL PE61" (trade name, available from Sanyo Chemical Industries, Ltd., polyethylene oxide/polypropylene oxide/polyethylene oxide block copolymer).

The chemical mechanical polishing (CMP) can be carried out by a publicly known method using a publicly known polishing aqueous dispersion. It is preferable to use, as the polishing aqueous dispersion, an aqueous dispersion containing silica as abrasives because the effect of the present invention can be efficiently exerted in the cleaning step after the chemical mechanical polishing.

The cleaning is not specifically restricted and can be carried out by a publicly known cleaning method. Examples of the cleaning methods include an immersion cleaning, a brush-scrub cleaning and an ultrasonic cleaning. The cleaning temperature is preferably in the range of 5 to 50°C. The cleaning time is in the range of preferably 1 to 5 minutes in case of the immersion cleaning, and it is in the range of preferably 0.2 to 2 minutes in case of the brush-scrub cleaning.

In the process for manufacturing a semiconductor device according to the invention, the sodium ion concentration in the semiconductor device after cleaning can be lowered to not more than 5×10¹⁰ atoms/cm², preferably not more than 5×10⁹ atoms/cm², and the potassium ion concentration in the semiconductor device after cleaning can be lowered to not more than 5×10¹¹ atoms/cm², preferably not more than 5×10¹⁰ atoms/cm². In the process for manufacturing a semiconductor device, further, the residues of abrasives can be decreased to not more than 1,000 particles/surface, preferably not more than 500 particles/surface. The value of the residues of abrasives is a value in terms of those on the whole surface of a substrate having a diameter of 8 inches.

### EFFECT OF THE INVENTION

According to the present invention, a cleaning composition for semiconductor components which exerts a high cleaning effect on impurities remaining on a polished surface of a semiconductor component after chemical mechanical polishing, such as abrasives, sodium ions and potassium ions, and becomes little burden to the environment can be provided.

By performing cleaning using the cleaning composition, a process for manufacturing a semiconductor device, which has no evil influence on the properties and performance of the semiconductor device, can be provided.

### EXAMPLES

The present invention is further described with reference to the following examples, but it should be construed that the invention is in no way limited to those examples.

In this specification, a weight-average molecular weight (Mw) of a water-soluble polymer is determined by converting a value of the polymer measured under the following conditions, by the use of a calibration curve that is formed using sodium polystyrenesulfonate as a standard sample.
Column: G3000PWXL, GMPWXL and GMPWXL (trade names, available from TOSOH CORPORATION; these three columns were connected in series in this order.)
Detector: differential refractometer RI-8021 (trade name, manufactured by TOSOH CORPORATION)
Eluent: water/acetonitrile/sodium sulfate (2,100/900/15, by weight)
Flow rate: 1.0 ml/min
Temperature: 40°C
Sample concentration: 0.2% by mass
Injection volume of sample: 400 µl

### <Synthesis Example 1>

### Synthesis of water-soluble polymer (synthesis of acrylic acid polymer)

To a 2-liter container containing 1,000 g of ion-exchanged water and 14 g of 35 % by mass hydrogen peroxide solution, 500 g of a 20 % by mass acrylic acid aqueous solution was constantly dropwise added over a period of 10 hours with stirring under reflux. After the dropwise addition was completed, the resulting mixture was held under reflux for another 2 hours to give an acrylic acid polymer (1) having Mw of 6,000.

Further, acrylic acid polymers (2) to (4) having Mw of 700, 2,000 and 4,000, respectively, were obtained in the same manner as in the above synthesis, except that the amount of the hydrogen peroxide water used was changed.

### <Synthesis Example 2>

### Synthesis of water-soluble polymer (synthesis of acrylic acid/methacrylic acid copolymer)

To a 2-liter container containing 400 g of ion-exchanged water and 100 g of 32 % by mass hydrogen peroxide solution, a mixture of 1400 g of a 50 % by mass acrylic acid aqueous solution and 100 g of a 50 % by mass methacrylic acid aqueous solution was constantly dropwise added over a period of 10 hours with stirring under reflux. After the dropwise addition was completed, the resulting mixture was held under reflux for another 2 hours to give an acrylic acid/methacrylic acid copolymer (1) having Mw of 24,000. A copolymerization ratio of the acrylic acid in the resulting copolymer was 93% by mass.

### <Synthesis Example 3>

### Synthesis of water-soluble polymer (synthesis of acrylic acid/acrylamide copolymer)

To a 2-liter container containing 400 g of ion-exchanged water and 100 g of 35 % by mass hydrogen peroxide solution, a mixture of 1200 g of a 20 % by mass acrylic acid aqueous solution and 300 g of a 20 % by mass acrylamide aqueous solution was constantly dropwise added over a period of 10 hours with stirring under reflux. After the dropwise addition was completed, the resulting mixture was held under reflux for another 2 hours to give an acrylic acid/acrylamide copolymer (1) having Mw of 78,000. A copolymerization ratio of the acrylic acid in the resulting copolymer was 80% by mass.

Further, an acrylic acid/acrylamide copolymer (2) having Mw of 140,000 was obtained in the same manner as in the above synthesis, except that the amounts of the hydrogen peroxide solution, the acrylic acid aqueous solution and the acrylamide aqueous solution used were changed to 50 g, 1000 g and 500 g, respectively. A copolymerization ratio of the acrylic acid was 66% by mass.

### <Synthesis Example 4>

### Synthesis of water-soluble polymer (synthesis of acrylic acid polymer contaminated with sodium ion)

An acrylic acid polymer (Na) having Mw of 6,000 was obtained in the same manner as in Synthesis Example 1, except that 12 g of a 5 % by mass sodium persulfate aqueous solution was used instead of the hydrogen peroxide solution. The total amount of sodium ions contained in the reaction mixture after polymerization was 1,200 ppm as a value based on the water-soluble polymer.

### <Example 1>

### (Preparation of cleaning composition for semiconductor components)

A solution containing the acrylic acid polymer (3) having Mw of 2,000 synthesized in Synthesis Example 1 in an amount corresponding to 10% by mass in terms of the polymer and tetramethylammonium hydroxide in an amount corresponding to 2% by mass were mixed with ion-exchanged water to prepare a concentrate of a cleaning composition for semiconductor components.

The concentrate was diluted to 50 times with ion-exchanged water to prepare a cleaning composition for semiconductor components.

### (1) Evaluation of Copper Etching Rate

A substrate of 8-inch diameter on which a copper film without pattern had been laminated (available from Advanced Technology Development Facility, Inc., substrate consisting of a silicon wafer and a copper film of 1,500 nm thickness without pattern laminated on the silicon wafer) was cut into a rectangle of 30 mm × 30 mm. This rectangular piece was immersed in the diluted cleaning composition at 25°C for 24 hours. After the immersion, a copper etching rate was calculated from a decrease in thickness of the copper film. The result is set forth in Table 2.

### (2) Evaluation of Influence on Low-Dielectric Constant Insulating Film

### (2-1) Preparation of Low-Dielectric Constant Insulating Film

A silicon substrate of 8-inch diameter with a thermally-oxidized film was coated with a low-dielectric constant insulating film "LKD5109" (trade name, available from JSR Corporation) by spin coating. The substrate was heated in an oven at 80°C for 5 minutes and then at 200°C for 5 minutes. Subsequently, the substrate was heated under vacuum at 340°C for 30 minutes, then at 360°C for 30 minutes, thereafter at 380°C for 30 minutes and further at 450°C for 1 hour. Thus, a colorless transparent low-dielectric constant film having a thickness of 2000 Å was formed on the substrate. The film had a dielectric constant of 2.2.

### (2-2) Evaluation of Change in Dielectric Constant

The substrate having the film formed as above was immersed in the diluted cleaning composition at 25°C for 60 minutes, and then an increase in the dielectric constant was measured. The result is set forth in Table 2.

### (3) Evaluation of Sodium-Decontamination Ability

### (3-1) Preparation of Substrate Contaminated with Sodium

A silicon substrate of 8-inch diameter with a PETEOS film (available from Advanced Technology Development Facility, Inc., substrate consisting of a silicon wafer and a PETEOS film of 1,000 nm thickness laminated on the wafer) was mounted on a chemical mechanical cleaning apparatus "EPO112" (manufactured by Ebara Corporation). Then, the substrate was treated with a 1% sodium sulfate aqueous solution under the following conditions to give a substrate having an insulating film contaminated with sodium. The quantity of sodium contamination of the substrate was 9×10¹⁴ atoms/cm².
Polishing pad: IC1000 (available from Rohm and Haas Electronic Materials)
Feed rate of sodium sulfate aqueous solution: 200 ml/min
Turn table rotating speed: 60 rpm
Head rotating speed: 63 rpm
Head pressure: 3 psi
Treatment time: 1 minute

### (3-2) Cleaning of Contaminated Substrate

The contaminated PETEOS substrate was mounted on a cleaning roll part of "EPO112" and cleaned with the diluted cleaning composition under the following conditions. The quantity of sodium contamination of the substrate after cleaning was measured. The result is set forth in Table 2.
Roll brush rotating speed:
   Upper roll brush: 120 rpm
   Lower roll brush: 120 rpm
Substrate rotating speed: 60 rpm
Feed rate of the cleaning composition: 500 ml/min to each of the upper and the lower surfaces of substrate
Cleaning time: 30 seconds

### (4) Evaluation of Ability to Remove Residual Abrasives

### (4-1) Chemical Mechanical Polishing Step

A substrate of 8-inch diameter on which a copper film without pattern had been laminated (available from Advanced Technology Development Facility, Inc., substrate consisting of a silicon wafer and a copper film of 1,500 nm thickness without pattern laminated on the wafer) was mounted on a chemical mechanical cleaning apparatus "EPO112" (manufactured by Ebara Corporation) and then chemically mechanically polished under the following conditions.

### Polishing pad: IC1000 (available from Rohm and Haas Electronic Materials)

Type of polishing aqueous dispersion: dispersion obtained by adding 31 % by mass hydrogen peroxide solution in an amount corresponding to 0.1% by mass in terms of pure hydrogen peroxide based on the total amount of the aqueous dispersion, to "CMS8301" (trade name, available from JSR Corporation, aqueous dispersion containing silica as abrasives)
Feed rate of polishing aqueous dispersion: 200 ml/min
Turn table rotating speed: 93 rpm
Head rotating speed: 100 rpm
Head pressure: 3 psi
Polishing time: 1 minute

The number of residual abrasives after chemical mechanical polishing was measured by means of a surface defect inspection system "KLA2351" (trade name, manufactured by KLA-Tencor Corporation) under the conditions of a pixel size of 0.62 µm and a threshold value of 90. The number of abrasives remaining on the substrate after chemical mechanical polishing was 25 particles based on the whole surface of the substrate.

### (4-2) Removal of Residual Abrasives

The substrate was cleaned in the same manner as in the above "(3-2) Cleaning of Contaminated Substrate". The number of abrasives on the substrate after cleaning was measured in the same manner as in the above (4-1). The result is set forth in Table 2.

### (5) Influence on Dishing of Copper Wiring

### (5-1) Chemical Mechanical Polishing Step

A test substrate of 8-inch diameter with a copper pattern "854CMP" (trade name, available from Advanced Technology Development Facility, Inc.) was loaded on a chemical mechanical cleaning apparatus "EPO112" (manufactured by Ebara Corporation) and then chemically mechanically polished in the same manner as in the above (4-1). In the substrate after chemical mechanical polishing, the degree of dishing of a wiring portion having a wiring width of 100 µm was measured, and as a result, it was 30 nm.

### (5-2) Evaluation of Change in Dishing

The substrate was cleaned in the same manner as in the above "(3-2) Cleaning of Contaminated Substrate". In the substrate after cleaning, the degree of dishing at the same position as in the above (5-1) was measured. The result is set forth in Table 2.

### <Examples 2-15 and Comparative Examples 1-6>

A cleaning composition for semiconductor components was prepared in the same manner as in Example 1, except that the formulation of the concentrate of the cleaning composition was changed as shown in Table 1. The cleaning composition was evaluated in the same manner as in Example 1. The results are set forth in Table 2.

### <Comparative Example 7>

Hydrogen peroxide was added into ion-exchanged water in an amount corresponding to 1% by mass to prepare a cleaning composition for semiconductor components. The cleaning composition was evaluated in the same manner as in Example 1. The results are set forth in Table 2.

### <Comparative Example 8>

Instead of the cleaning composition for semiconductor components, an ion-exchanged water was evaluated in the same manner as in Example 1. The results are set forth in Table 2.

**Table 1 Formulation of concentrate of cleaning composition for semiconductor components**

| | Water-soluble polymer | | | | N(CH₃)₄OH | Antioxidant | | Complexing agent | | pH |
|---|---|---|---|---|---|---|---|---|---|---|
| | Type | Weight-average molecular weight (Mw) | Na content in polymer mixture (ppm/polymer) | Amount (% by mass) | Amount (% by mass) | Type | Amount (% by mass) | Type | Amount (% by mass) | |
| Ex.1 | AA polymer (3) | 2,000 | 0.15 | 10 | 2 | - | 0 | - | 0 | 4.5 |
| Ex.2 | AA polymer (4) | 4,000 | 0.16 | 10 | 3 | - | 0 | - | 0 | 4.7 |
| Ex.3 | AA polymer (1) | 6,000 | 0.08 | 10 | 4 | - | 0 | - | 0 | 4.9 |
| Ex.4 | AA polymer (1) | 6,000 | 0.08 | 10 | 5 | - | 0 | - | 0 | 5.8 |
| Ex.5 | AA polymer (1) | 6,000 | 0.08 | 5 | 4 | - | 0 | - | 0 | 6.4 |
| Ex.6 | AA polymer (1) | 6,000 | 0.08 | 5 | 6 | - | 0 | - | 0 | 13.2 |
| Ex.7 | AA polymer (1) | 6,000 | 0.08 | 5 | 8 | - | 0 | - | 0 | 13.9 |
| Ex.8 | AA/MA copolymer (1) (93/7, by mass) | 24,000 | 0.20 | 5 | 10 | - | 0 | - | 0 | 14.3 |
| Ex.9 | AA/AM copolymer (1) (80/20, by mass) | 78,000 | 0.25 | 2.5 | 4 | - | 0 | - | 0 | 13.4 |
| Ex.10 | AA polymer (1) | 6;000 | 0.08 | 10 | 4 | - | 0 | glycine | 5 | 5.5 |
| Ex.11 | AA polymer (1) | 6,000 | 0.08 | 10 | 4 | - | 0 | citric acid | 5 | 4.1 |
| Ex.12 | AA polymer (1) | 6,000 | 0.08 | 5 | 8 | - | 0 | glycine | 5 | 10.1 |
| Ex.13 | AA polymer (1) | 6,000 | 0.08 | 5 | 8 | - | 0 | citric acid | 5 | 8.4 |
| Ex.14 | AA polymer (1) | 6,000 | 0.08 | 5 | 8 | L-ascorbic acid | 2 | - | 0 | 8.9 |
| Ex.15 | AA polymer (Na) | 6,000 | 1,200 | 5 | 8 | - | 0 | - | 0 | 13.9 |
| Comp.Ex.1 | AA polymer (1) | 6,000 | 0.08 | 5 | 0 | - | 0 | - | 0 | 2.1 |
| Comp.Ex.2 | - | - | - | 0 | 8 | - | 0 | - | 0 | 14.9 |
| Comp.Ex.3 | AA polymer (1) | 6,000 | 0.08 | 5 | 0 | - | 0 | ammonia | 2 | 8.4 |
| Comp.Ex.4 | AA polymer (2) | 700 | 0.24 | 5 | 8 | - | 0 | - | 0 | 13.4 |
| Comp.Ex.5 | AA/AM, copolymer) (2) (66/34, by mass) | 140,000 | 0.18 | 5 | 8 | - | 0 | - | 0 | 14.1 |
| Comp. Ex.6 | - | - | - | 0 | 0 | - | 0 | citric acid | 10 | 1.9 |
| Comp.Ex.7 | - | - | - | 0 | 0 | - | 0 | - | 0 | 13.9 |
| Comp.Ex.8 | - | - | - | 0 | 0 | - | 0 | - | 0 | 6.8 |

| | | | | | | | | | | |
|---|---|---|---|---|---|---|---|---|---|---|
| AA: acrylic acid, MA: methacrylic acid, AM: acrylamide Notes: In Comp. Ex. 7, hydrogen peroxide was added into ion-exchanged water in an amount corresponding to 1% by mass. In Comp. Ex. 8, an ion-exchanged water was used alone. | | | | | | | | | | |

**Table 2 Results of evaluation of cleaning composition for semiconductor components (composition obtained by diluting concentrate to 50 times)**

| | pH | Na content in composition (ppm) | Copper etching rate (nm/min) | Influence on low-dielectric constant insulating film insulating film (change in dielectric constant) | Results of substrate cleaning | | |
|---|---|---|---|---|---|---|---|
| | | | | | Quantity of Na contamination (×10¹⁰ atoms/cm²) | Number of residual abrasives (particles/ substrate) | Change in dishing of copper wiring (nm) |
| Ex.1 | 4.7 | 0.003 | 0.07 | +0.1 | 2 | 122 | +5 |
| Ex.2 | 5.1 | 0.003 | 0.12 | +0.1 | 3 | 150 | +4 |
| Ex.3 | 5.5 | 0.002 | 0.13 | +0.1 | 4 | 285 | +5 |
| Ex.4 | 6.0 | 0.002 | 0.14 | +0.1 | 3 | 327 | +5 |
| Ex.5 | 8.2 | 0.002 | 0.31 | +0.1 | 4 | 250 | +3 |
| Ex.6 | 10.6 | 0.002 | 0.05 | +0.1 | 2 | 129 | +6 |
| Ex.7 | 11.7 | 0.002 | 0.04 | +0.1 | 1 | 150 | +9 |
| Ex.8 | 13.1 | 0.004 | 0.04 | +0.1 | 3 | 185 | +7 |
| Ex.9 | 12.1 | 0.005 | 0.04 | +0.1 | 4 | 195 | +5 |
| Ex.10 | 5.8 | 0.002 | 0.61 | +0.1 | 3 | 185 | +11 |
| Ex.11 | 4.9 | 0.002 | 0.32 | +0.1 | 3 | 135 | +12 |
| Ex.12 | 9.1 | 0.002 | 0.64 | +0.1 | 4 | 185 | +9 |
| Ex.13 | 7.8 | 0.002 | 0.53 | +0.1 | 2 | 155 | +15 |
| Ex.14 | 7.9 | 0.002 | 0.09 | +0.1 | 3 | 185 | +2 |
| Ex.15 | 11.7 | 24.0 | 0.04 | +0.1 | 85 | 195 | +4 |
| Comp.Ex.1 | 3.1 | 0.002 | 0.21 | +0.1 | 28 | 95,000 | +4 |
| Comp.Ex.2 | 13.2 | 0. | 0.96 | +0.9 | 4 | 110,000 | +38 |
| Comp.Ex.3 | 7.8 | 0.002 | 1.02 | +0.4 | 3 | 125 | +55 |
| Comp.Ex.4 | 12.4 | 0.005 | 0.04 | +0.1 | 12 | 4,800 | +3 |
| Comp.Ex.5 | 11.9 | 0.004 | 0.15 | +0.1 | 25 | 8,900 | +3 |
| Comp.Ex.6 | 2.7 | 0 | 0.21 | +0.6 | 4 | 7,550 | +6 |
| Comp.Ex.7 | 13.1 | 0 | 0.03 | +0.7 | 3 | 125 | +230 |
| Comp.Ex.8 | 6.8 | 0 | 0.03 | +0.1 | 35 | 5,540 | +9 |

### <Examples 16-25 and Comparative Examples 9-12>

### (Preparation of cleaning composition for semiconductor components)

A concentrate of a cleaning composition for semiconductor components was prepared in the same manner as in Example 1, except that the formulation of the concentrate of the cleaning composition was changed as shown in Table 3. The concentrate was diluted to 25 times with ion-exchanged water to prepare a cleaning composition for semiconductor components.

In Table 3, "EDTA" represents ethylenediaminetetraacetic acid, and "-" indicates that a component relevant to the corresponding column was not added.

### (1) Evaluation of Copper Etching Rate

A copper etching rate was calculated in the same manner as in the aforesaid "(1) Evaluation of Copper Etching Rate" in Example 1. The results are set forth in Table 4. -

### (2) Evaluation of Influence on Low-Dielectric Constant Insulating Film

A silicon substrate wherein a low-dielectric constant insulating film had been laminated in a silicon wafer 000LKD304" (trade name, available from Advanced Technology Development Facility, Inc., substrate consisting of a silicon wafer of 8-inch diameter and a low dielectric constant film "LKD5109" (available from JSR Corporation, dielectric constant: 2.2) of 4000 Å thickness without pattern formed on the wafer) was immersed in the diluted cleaning composition at 25°C for 60 minutes. After the immersion, an increase in the dielectric constant was measured. The results are set forth in Table 4.

### (3) Evaluation of Cleaning Ability after Chemical Mechanical Polishing Step

### (3-1) Chemical Mechanical Polishing Step

A test substrate of 8-inch diameter with a copper pattern "854CMP" (trade name, available from Advanced Technology Development Facility, Inc.) was mounted on a chemical mechanical cleaning apparatus "EPO112" (manufactured by Ebara Corporation) and then subjected to two-stage polishing under the following conditions using a polishing pad "IC1000" (trade name, available from Rohm and Haas Electronic Materials).

### <First polishing stage>

Type of polishing aqueous dispersion: mixture of CMS7401, CMS7452 (trade names, available from JSR Corporation, aqueous dispersions containing silica as abrasives), ion-exchanged water and 4 % by mass ammonium sulfate aqueous solution in a mixing ratio of 1:1:2:4 by volume
Feed rate of polishing aqueous dispersion: 300 ml/min
Turn table rotating speed: 60 rpm
Head rotating speed: 60 rpm
Head pressure: 3 psi
Polishing time: 140 seconds

### <Second polishing stage>

Type of polishing aqueous dispersion: mixture of CMS8401, CMS8452 (trade names, available from JSR Corporation, aqueous dispersions containing silica as abrasives) and ion-exchanged water in a mixing ratio of 1:2:3 by volume
Feed rate of polishing aqueous dispersion: 200 ml/min
Turn table rotating speed: 50 rpm
Head rotating speed: 50 rpm
Head pressure: 5 psi
Polishing time: 60 seconds
Through the above-mentioned two-stage polishing, excess copper and barrier metal other than those of the wiring portion of "854CMP" were removed.

### (3-2) Cleaning of Substrate after Polishing

### Two-stage cleaning was carried out under the following conditions.

### <On-table cleaning>

The substrate after chemical mechanical polishing was subjected to on-table cleaning under the following conditions without taking out the substrate from the chemical mechanical polishing apparatus and using the diluted cleaning composition instead of the polishing aqueous dispersion.
Feed rate of cleaning composition for semiconductor components: 500 ml/min
Turn table rotating speed: 50 rpm
Head rotating speed: 50 rpm
Head pressure: 2 psi
Cleaning time: 30 seconds

### <Roll brush cleaning>

The substrate after the on-table cleaning was mounted on a cleaning roll part of "EPO112" and then subjected to roll brush cleaning with the same cleaning composition as used in the above "On-table cleaning" under the following conditions.
Roll brush rotating speed:
   Upper roll brush: 120 rpm
   Lower roll brush: 120 rpm
Substrate rotating speed: 60 rpm
Feed rate of the cleaning composition: 500 ml/min to each of the upper and the lower surfaces of substrate
Cleaning time: 30 seconds

### (3-3) Evaluation of Substrate after Cleaning

The substrate after the two-stage cleaning was measured on the number of residual abrasives, the number of scratches, the number of small dots and surface roughness on the cleaned surface in the following manner.

The whole surface of the substrate after cleaning was inspected by a surface defect inspection system "KLA2351" (trade name, manufactured by KLA-Tencor Corporation) under the conditions of a pixel size of 0.62 µm and a threshold value of 90 to measure the total number of defects. Of the defects, 100 defects were selected at random, and they were examined on their shapes, etc. on a monitor of "KLA2351" to determine a proportion of scratches and a proportion of small dots among the 100 defects. The resulting values were each multiplied by the total number of defects to calculate the number of scratches and the number of small dots based on the whole surface of the polished surface. Further, the surface appearance in the vicinity of the defects displayed on the monitor was observed to judge the presence of surface roughness.

The "small dots" referred to herein mean blackish deposits on the polished surface among the surface defects counted by the surface defect inspection system "KLA2351". It has been presumed that copper oxide having been eluted from the polished surface during the chemical mechanical polishing was deposited on the polished surface again to form these small dots.

The results are set forth in Table 4.

**Table 3 Recipe for concentrate of cleaning composition for semiconductor components**

| | Water-soluble polymer | | | | N(CH₃)₄OH | Antioxidant | | Complexing agent | | pH |
|---|---|---|---|---|---|---|---|---|---|---|
| | Type | Weight-average molecular weight (Mw) | Na content in polymer mixture (ppm/polymer) | Amount (% by mass) | Amount (% by mass) | Type | Amount (% by mass) | Type | Amount (% by mass) | |
| Ex.16 | AA polymer (3) | 2,000 | 0.15 | 12.5 | 8.5 | L-ascorbic acid | 7.5 | EDTA | 2.5 | 5.0 |
| Ex.17 | AA polymer (3) | 2,000 | 0.15 | 2.5 | 2.5 | erysorbic acid | 2.5 | glycine | 2.5 | 6.0 |
| Ex.18 | AA polymer (3) | 2,000 | 0.15 | 7.5 | 15.0 | oxalic acid | 7.5 | EDTA | 5.0 | 7.0 |
| Ex.19 | AA polymer (1) | 6,000 | 0.08 | 2.5 | 5.5 | L-ascorbic acid | 7.5 | alanine | 2.5 | 4.1 |
| Ex.20 | AA/MA copolymer (1) (93/7, by mass) | 24,000 | 0.20 | 5.0 | 10.0 | L-ascorbic acid | 7.5 | EDA | 2.5 | 6.0 |
| Ex.21 | AA/AM copolymer (1) (80/20, by mass) | 78,000 | 0.25 | 2.5 | 4.5 | erysorbic acid | 5.0 | glycine | 5.0 | 5.5 |
| Ex.22 | AA polymer (3) | 2,000 | 0.15 | 6.25 | 8.0 | oxalic acid | 6.25 | alanine | 5.0 | 4.3 |
| Ex.23 | AA polymer (4) | 4,000 | 0.16 | 2.5 | 7.5 | gallic acid | 7.5 | glycine | 2.5 | 5.0 |
| Ex.24 | AA polymer (4) | 4,000 | 0.16 | 5.0 | 2.75 | erysorbic acid | 7.5 | EDA | 2.5 | 7.0 |
| Ex.25 | AA polymer (4) | 4,000 | 0.16 | 10.0 | 10.0 | oxalic acid | 2.5 | glycine | 2.5 | 5.0 |
| Comp. Ex. 9 | - | - | - | - | 5.0 | erysorbic acid | 3.75 | EDTA | 2.5 | 10.3 |
| Comp. Ex. 10 | AA polymer (4) | 4,000 | 0.16 | 2.5 | - | L-ascorbic acid | 2.5 | - | - | 3.0 |
| Comp. Ex. 11 | - | - | - | - | 2.5 | oxalic acid | 2.5 | - | - | 5.1 |
| Comp. Ex. 12 | - | - | - | - | 3.25 | - | - | glycine | 5.0 | 9.3 |

| | | | | | | | | | | |
|---|---|---|---|---|---|---|---|---|---|---|
| AA: acrylic acid, MA: methacrylic acid, AM: acrylamide, EDA: ethylenediamine | | | | | | | | | | |

**Table 4 Evaluation results of cleaning composition for semiconductor components (composition obtained by diluting concentrate to 25 times)**

| | pH | Na content in composition (ppm) | Copper etching rate (nm/min) | Influence on low-dielectric constant insulating film (change in dielectric constant) | Number of residual abrasives (particles /substrate) | Cleaning test after chemical mechanical polishing | | |
|---|---|---|---|---|---|---|---|---|
| | | | | | | Number of scratches (scratches /surface) | Number of small dots (dots/surface) | Surface roughness |
| Ex.16 | 5.8 | 0.01 | 0.26 | 0.09 | 24 | 694 | 173 | not observed |
| Ex.17 | 6.5 | 0.02 | 0.06 | 0.09 | 21 | 775 | 184 | not observed |
| Ex.18 | 7.1 | 0.03 | 0.33 | 0.11 | 19 | 571 | 204 | not observed |
| Ex.19 | 4.8 | 0.01 | 0.15 | 0.08 | 32 | 816 | 102 | not observed |
| Ex.20 | 6.4 | 0.02 | 0.44 | 0.02 | 39 | 704 | 163 | not observed |
| Ex.21 | 6.1 | 0.03 | 0.22 | 0.03 | 41 | 898 | 179 | not observed |
| Ex.22 | 4.9 | 0.01 | 0.22 | 0.08 | 19 | 643 | 186 | not observed |
| Ex.23 | 5.9 | 0.01 | 0.26 | 0.07 | 22 | 755 | 133 | not observed |
| Ex.24 | 7.1 | 0.02 | 0.54 | 0.08 | 35 | 867 | 224 | not observed |
| Ex.25 | 5.5 | 0.04 | 0.33 | 0.03 | 39 | 673 | 326 | not observed |
| Comp. Ex.9 | 9.9 | 0.02 | 0.92 | 0.82 | 2190 | 3590 | 163 | somewhat observed |
| Comp. Ex.10 | 3.6 | 0.03 | 0.09 | 0.11 | 1590 | 785 | 2683 | not observed |
| Comp. Ex.11 | 5.9 | 0.02 | 0.29 | 0.08 | 4920 | 2734 | 520 | not observed |
| Comp. Ex.12 | 8.9 | 0.01 | 1.21 | 0.71 | 1980 | 459 | 166 | markedly observed |

## Claims

1. A cleaning composition for semiconductor components comprising a water-soluble polymer (a) having a weight-average molecular weight in terms of sodium polystyrenesulfonate, as measured by gel permeation chromatography, of 1,000 to 100,000 and a compound (b) represented by the following formula (1):
NR₄OH (1)
wherein each R is independently a hydrogen atom or an alkyl group of 1 to 6 carbon atoms.

2. The cleaning composition as claimed in claim 1, comprising at least one of the water-soluble polymer and the compound (b) in at least one state of the dissociative state and the recombined state with a counter ion after dissociation.

3. The cleaning composition as claimed in claim 1, wherein the water-soluble polymer (a) has a carboxyl group.

4. The cleaning composition as claimed in claim 1, wherein the compound (b) is tetramethylammonium hydroxide.

5. The cleaning composition as claimed in claim 1, further comprising at least one agent selected from the group consisting of an antioxidant (c) and a complexing agent (d).

6. The cleaning composition as claimed in any one of claims 1 to 5, wherein the semiconductor component is a copper semiconductor substrate.

7. A process for manufacturing a semiconductor device, comprising chemical mechanical polishing a semiconductor component, and cleaning the semiconductor component with the cleaning composition of any one of claims 1 to 5.

8. The process for manufacturing a semiconductor device as claimed in claim 7, wherein the semiconductor component is a copper semiconductor substrate.

## Patentansprüche

1. Reinigungszusammensetzung für Halbleiterbestandteile, die ein wasserlösliches Polymer (a) mit einem Gewichtsmittel des Molekulargewichts, bezogen auf Natriumpolystyrolsulfonat, gemessen mittels Gelpermeationschromatografie, von 1.000 bis 100.000 und eine Verbindung (b) umfasst, die durch die nachstehende Formel (1) wiedergegeben wird:
NR₄OH (1)
worin jedes R unabhängig ein Wasserstoffatom oder eine Alkylgruppe mit 1 bis 6 Kohlenstoffatomen ist.

2. Reinigungszusammensetzung nach Anspruch 1, die mindestens ein Polymer des wasserlöslichen Polymers und die Verbindung (b), in mindestens einem Zustand, ausgewählt aus dem dissoziierten Zustand und dem mit einem Gegenion nach der Dissoziation rekombinierten Zustand, umfasst.

3. Reinigungszusammensetzung nach Anspruch 1, worin das wasserlösliche Polymer (a) eine Carboxylgruppe aufweist.

4. Reinigungszusammensetzung nach Anspruch 1, worin die Verbindung (b) Tetramethylammoniumhydroxid ist.

5. Reinigungszusammensetzung nach Anspruch 1, die des Weiteren mindestens ein Mittel umfasst, das aus der Gruppe ausgewählt ist, die aus einem Antioxidans (c) und einem Komplexbildner (d) besteht.

6. Reinigungszusammensetzung nach einem der Ansprüche 1 bis 5, wobei der Halbleiterbestandteil ein Kupferhalbleitersubstrat ist.

7. Verfahren zur Herstellung einer Halbleitervorrichtung, das das chemisch-mechanische Polieren eines Halbleiterbestandteils, und das Reinigen des Halbleiterbestandteils mit der Reinigungszusammensetzung nach einem der Ansprüche 1 bis 5 umfasst.

8. Verfahren zur Herstellung einer Halbleitervorrichtung nach Anspruch 7, worin der Halbleiterbestandteil ein Kupferhalbleitersubstrat ist.

## Revendications

1. Composition de nettoyage pour composants semiconducteurs comprenant un polymère soluble dans l'eau (a) ayant un poids moléculaire moyen en poids en termes de polystyrènesulfonate de sodium, tel que mesuré par chromatographie par perméation sur gel de 1 000 à 100 000 et un composant (b) représenté par la formule suivante :
NR₄OH (1)
dans laquelle chaque R représente indépendamment un atome d'hydrogène ou un groupe alkyle de 1 à 6 atome(s) de carbone.

2. Composition de nettoyage telle que revendiquée selon la revendication 1, comprenant au moins l'un parmi le polymère soluble dans l'eau et le composé (b) en au moins un état parmi l'état dissocié et l'état recombiné avec un contre ion après dissociation.

3. Composition de nettoyage telle que revendiquée selon la revendication 1, dans laquelle le polymère soluble dans l'eau (a) possède un groupe carboxyle.

4. Composition de nettoyage telle que revendiquée selon la revendication 1, dans laquelle le composé (b) est l'hydroxyde de tétraméthylammonium.

5. Composition de nettoyage telle que revendiquée selon la revendication 1, comprenant en outre au moins un agent choisi parmi le groupe constitué d'un antioxydant (c) et d'un agent complexant (d).

6. Composition de nettoyage telle que revendiquée selon l'une quelconque des revendications 1 à 5, dans laquelle le composant semi-conducteur est un substrat semi-conducteur en cuivre.

7. Procédé de fabrication d'un dispositif semi-conducteur, comprenant le polissage chimico-mécanique d'un composant semi-conducteur, et le nettoyage du composant semi-conducteur avec la composition de nettoyage selon l'une quelconque des revendications 1 à 5.

8. Procédé de fabrication d'un dispositif semi-conducteur tel que revendiqué selon la revendication 7, dans lequel le composant semi-conducteur est un substrat semi-conducteur en cuivre.
